# EUROPEAN PATENT APPLICATION

(11) **EP 3 182 453 A1**
(43) Date of publication of application: **21.06.2017**
(21) Application number: 15200731.6
(22) Date of filing: 17.12.2015
(51) Int. Cl.: H01L 27/146, H04N 9/04, H04N 9/07

(54) **IMAGE SENSOR FOR A VISION DEVICE AND VISION METHOD FOR A MOTOR VEHICLE**

(71) Applicant: Autoliv Development AB, 447 83 Vårgårda (SE)
(72) Inventor: Knutsson, Per, 58238 Linköping (SE)
(74) Representative: Müller Verweyen

(57) **Abstract**

An image sensor (21) for a vision device of a motor vehicle, said image sensor (21) comprising a sensor array (22) and a color filter array (23) arranged on top of said sensor array (22), said color filter array (23) having of a plurality of pixel filters, wherein said pixel filters consist of first color pixels, second color pixels and transparent pixels, characterized in that said first and second color pixels are chosen from the group consisting of Cyan, Magenta, Yellow.

## Description

The invention relates to an image sensor for a vision device in particular of a motor vehicle, said image sensor comprising a sensor array and a color filter array arranged on top of said sensor array, said filter array having of a plurality of pixel filters, wherein said pixel filters comprise first color pixels, second color pixels and transparent pixels. The invention also relates to a vision method for a motor vehicle using such image sensor.

A color filter array (CFA) on top of the sensor array of an imaging sensor in a camera is used to obtain color information in the captured images, which generally allows to obtain better results in subsequent image processing. A conventional color filter array used in particular in the automotive industry is the Bayer filter or RGGB filter composed of 2 x 2 pixel patterns with two green pixels arranged diagonally and one blue pixel plus one red pixel arranged diagonally. However, RGB filters like the Bayer filter have the drawback that most photons are rejected by the color filter, thereby reducing the sensitivity of the image sensor, leading to poor performance in particular under low light conditions, for example at night time.

In order to improve the sensitivity of the image sensor it is known to use CMY colors for color filters, for example in a CYYM filter having a 2 x 2 pixel pattern with two Yellow pixels arranged diagonally, and one Cyan pixel plus one Magenta pixel arranged diagonally.

It is also known to use transparent pixel filters, also called clear pixels or white pixels, in the color filter array, which do not provide color filtering but let the incoming light pass unfiltered, thus also improving the sensitivity of the image sensor. Known examples comprise Red-Clear-Clear-Clear (RCCC) filters, see US 2010/0134616 A1, Red-Clear-Clear-Blue (RCCB) filters, filters comprising RGB and transparent pixels, see US 8,723,995 B2, and CMYW filters comprising CMY and white pixels.

The problem underlying the present solution is to provide an image sensor giving sufficient color information of the captured images with improved sensitivity in particular under low light conditions, and a vision method using such image sensor.

The invention solves this problem with the features of the independent claims. The combination of transparent pixels (also called clear or white pixels) with two different color pixels taken from the group consisting of Cyan, Magenta, Yellow provides full color information but with much improved sensitivity over RGB based sensors. It has been realized that two colors taken from Cyan, Magenta, Yellow, in combination with transparent pixels, are fully sufficient for obtaining color information, such that the third color of Cyan, Magenta, Yellow can be dispensed with, without significant loss in color information. Even more, replacing the third color of Cyan, Magenta, Yellow by transparent leads to an improved sensitivity of the invention over CMYW sensors employing all three of Cyan, Magenta, Yellow.

It is also possible to reconstruct RGB colors from the digital image information provided by the image sensor of the invention.

The advantage of the filter array of the invention is that daytime color information comparable to RGB filters is provided, but capability to distinguish objects under dark conditions is significantly enhanced over RGB filters. This is particularly useful in subsequent image processing where color is used, in particular in classification algorithms. Examples of classification algorithms where color is used, in addition to shapes of objects for example, are traffic sign recognition, lane identification and/or light source recognition.

Preferably the first and second color pixels are Magenta and Cyan pixels. In other words, the filter array is exclusively composed of three types of pixels, namely transparent pixels, Magenta pixels and Cyan pixels. Transparent pixel filters do not absorb any color, but are intended to let pass all colors or wavelengths between 400 nm and 700 nm unaffected. Magenta pixels ideally completely absorb all light in a window between 500 nm and 600 nm and transmit all visible light outside this window. In reality, Magenta provides strong absorption in a window approximately between 500 nm and 600 nm and weaker absorption outside this window. Cyan pixels ideally completely absorb all light in a window between 600 nm and 700 nm and transmit all visible light outside this window. In reality, Cyan provides strong absorption in a window approximately between 600 nm and 700 nm and weaker absorption outside this window.

Magenta pixel filters mainly filter out green light, which is mostly found in daylight. Cyan pixel filters mainly filter out yellow, orange and red light. Lights of interest at night, apart from the colors on traffic signs and the like, are vehicle halogen lights, which comprise mainly red light, and vehicle xenon lights, which comprise mainly white light.

In other embodiments of the invention, the first and second color pixels are Yellow and Magenta pixels; or Yellow and Cyan pixels. Yellow pixels ideally completely absorb all light in a window between 400 nm and 500 nm and transmit all visible light outside this window. In reality, Yellow provides strong absorption in a window approximately between 400 nm and 500 nm and weaker absorption outside this window.

Preferably the filter array is composed of basic patterns of 2 x 2 pixels with two transparent pixels arranged diagonally and first color pixel second color pixel arranged diagonally. With such arrangement the color channels will create a regular 2-dimensional pattern which will provide regular sampling of each color channel over the whole filter array. Therefore, every color channel has the same sampling or Nyquist frequency in both x- and y- dimensions over the filter array.

The above described inventive filter array has an overall sensitivity comparable to an RCCC filter array, better than Bayer filter array, which is especially important for detecting objects during dark or nighttime conditions. The color separability is comparable to Bayer filter, better than RCCC, which is especially important for classification of objects such as lane markings, traffic signs and light sources.

In the following the invention shall be illustrated on the basis of preferred embodiments with reference to the accompanying drawings, wherein:
- Fig. 1: shows a schematic drawing of a vision system for a motor vehicle; and
- Fig2. 2-7: show schematic patterns for color filter arrays in different embodiments of the invention.

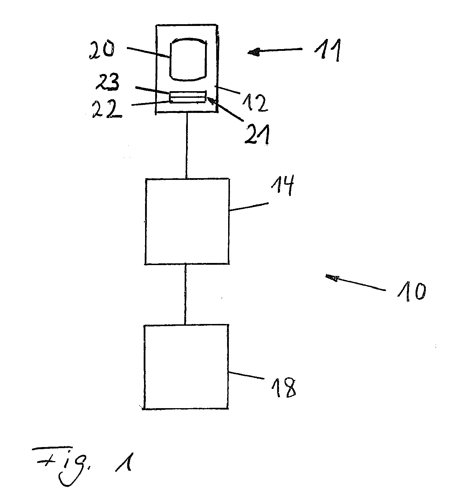

The vision system 10 is mounted in a motor vehicle and comprises an imaging apparatus 11 for acquiring images of a region surrounding the motor vehicle, for example a region in front of the motor vehicle. The imaging apparatus 11 comprises one or more optical imaging devices 12, in particular cameras, operating in the visible wavelength range. In the preferred embodiment shown in Figure 1, only one imaging device 12 forming a mono imaging apparatus 11 is used. In other embodiments not shown in the Figures, the imaging apparatus 11 comprises a plurality imaging devices 12 in particular forming a stereo imaging apparatus 11.

The imaging apparatus 11 is coupled to a data processing device 14 adapted to process the image data received from the imaging apparatus 11. The image and data processing carried out in the processing device 14 by corresponding software advantageously comprises identifying and preferably also classifying possible objects in front of the motor vehicle, such as pedestrians, other vehicles, bicyclists and/or large animals, tracking over time the position of object candidates identified in the recorded images, and activating or controlling at least one driver assistance device 18 depending on an estimation performed with respect to a tracked object, for example an estimated collision probability. The driver assistance device 18 may in particular comprise a display device to display information relating to a detected object. However, the invention is not limited to a display device. The driver assistance device 18 may in addition or alternatively comprise a warning device adapted to provide a collision warning to the driver by suitable optical, acoustical and/or haptic warning signals; one or more restraint systems such as occupant airbags or safety belt tensioners, pedestrian airbags, hood lifters and the like; and/or dynamic vehicle control systems such as brake or steering control devices.

The data processing device 14 is preferably a digital device which is programmed or programmable and preferably comprises a microprocessor, micro-controller, digital signal processor (DSP) or a System-On-Chip (SoC) device. The data processing device 14 is preferably realised in an on-board electronic control unit (ECU) and may be connected to the imaging apparatus 11 via a separate cable or a vehicle data bus. In another embodiment the ECU and one or more of the imaging devices 12 can be integrated into a single unit, where a one box solution including the ECU and all imaging devices 12 can be preferred. All steps from imaging, image pre-processing, image processing to possible activation or control of driver assistance device 18 are performed automatically and continuously during driving in real time.

The optical imaging device 12 comprises an optics arrangement 20 with one or more optical elements like optical lenses adapted to direct incidenting light on an image sensor 21, which is adapted to convert the incidenting light into an electrical signal comprising the image information. The image sensor 21 comprises a two-dimensional light sensitive sensor array 22, usually made of a semiconductor material and usually organized in a matrix of sensor pixels. The electrical signal comprising the image information is transmitted from the image sensor 21 to the data processing device 14 for data and image processing, as described above.

The optical imaging device 12 furthermore comprises a color filter or color filter array (CFA) 23, which is arranged in the light path within the camera 12 directly on top of the sensor array 22, such that the filter array 23 is part of the image sensor 21. The filter array 22 is expediently composed of a matrix of pixel filters which are arranged in corresponding relationship to the sensor pixels of the sensor array 22.

In a preferred embodiment, the color filter array 23 is composed of Magenta, Cyan and Transparent pixel filters. Preferably 25% of all pixel filters are Magenta pixels, 25% of all pixel filters are Cyan pixels, and 50% of all pixels are transparent pixels.

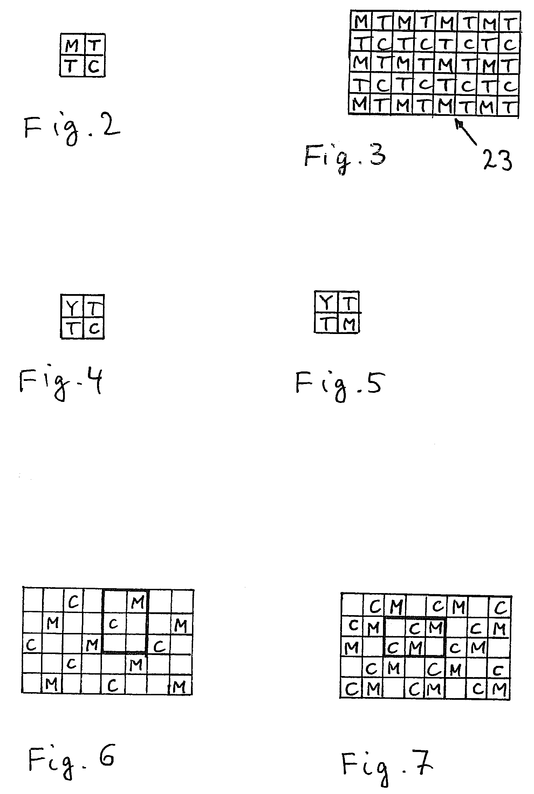

A practical embodiment is shown in Figures 2 and 3. Here the color filter 23 is composed of a basic pattern of 2 x 2 pixels shown in Figure 2, where two transparent pixels T are arranged diagonally and one Magenta pixel M and one Cyan pixel C are arranged diagonally on the other diagonal. Here and below, the color filter 23 is built from multiple n x m (for example, 2 x 2) patches, where n and m are integers > 1, where all patches have the same pattern and are set one next to the other, thus forming a regular scheme.

A filter array 23 composed of the repeating pattern of Figure 2 is shown in Figure 3 for an example of an 8 x 5 pixel CFA, where it should be understood that in reality the filter array 23 comprises many more, normally hundred thousands to millions of pixels.

An alternative basic pattern of 2 x 2 pixels is shown in Figure 4, where two transparent pixels T are arranged diagonally and one Yellow pixel Y and one Cyan pixel C are arranged diagonally on the other diagonal.

Another very preferred embodiment is shown in Figure 5, where a basic pattern of 2 x 2 pixels has two transparent pixels T are arranged diagonally and one Yellow pixel Y and one Magenta pixel M are arranged diagonally on the other diagonal.

As can be seen from the above, the number of colored pixel filters preferably equals the number of transparent pixel filters in the filter array 23. However, this is not a strict requirement. Preferably, the ratio of colored pixel filters to transparent pixel filters in the filter array 23 lies in the range between 0.5 and 2, more preferably between 2/3 to 1.5, even more preferably between 0.75 and 4/3. Similarly, the number of pixel filters of one color preferably equals the number of pixel filters of the other color in the filter array 23. However, this is not a strict requirement. Preferably, the ratio of pixel filters of one color to transparent pixel filters of the other color in the filter array 23 lies in the range between 0.5 and 2, more preferably between 2/3 to 1.5, even more preferably between 0.75 and 4/3.

The above is illustrated with the schematic embodiments of the filter array 23 shown in Figures 6 and 7. In the embodiment of Figure 6, the ratio of colored pixel filters to transparent pixel filters in the filter array 23 is 0,5. Here, a basic pattern of 2 x 3 pixels has been marked by a bold line. In the embodiment of Figure 7, the ratio of colored pixel filters to transparent pixel filters in the filter array 23 is 2:1. Here as well, a basic pattern of 3 x 2 pixels has been marked by a bold line. In Figures 6 and 7, the transparent pixel filters have been left blank.

An insignificantly small number of irregularly colored pixels, apart from the two CMY colors under the invention, should be considered as falling under the invention. A number of pixels may be considered insignificantly small of it amounts to at most 10%, preferably at most 5%, more preferably at most 2%, even more preferably at most 1% of the total number of pixel filters.

It is also possible to reconstruct RGB colors from the digital image information provided by the image sensor 21 of the invention using the following conversion equations: Red = Transparent - Cyan; Green = Transparent - Magenta; Blue = Transparent - Yellow; Transparent = Red + Green + Blue. Using these equations, RGB colors can be reconstructed for any filter array under the invention. For YTTC filter array, for example, Magenta is eliminated from the above equations yielding: Blue = Transparent - Yellow; Green = Yellow + Cyan - Transparent; Red = Transparent - Cyan.

The spectral sensitivity of transparent pixels is defined by the combined response of the image sensor 22 and transmission through the optics arrangement 20. More specifically, the spectral sensitivity of transparent pixels results from the sensitivity of the sensor array 22 and cut-off filters in the lenses of the optics arrangement 20. The individual transparent pixels do not have additional color filters. The lens or lenses in the optics arrangement 20 and/or inherent sensitivity of the silicon sensor array 22 hence defines the broadband transparent wavelength range [λ_{T, low}, λ_{T, high}].

The spectral sensitivity of the CMY colors under the invention are further defined by additional color filters in front of each pixel of the sensor array 22, as described above. These color filters together with the lens and sensor array sensitivity are hence defining lower and higher sensitivity limits for each CMY color channel as [λ_{C, low}, λ_{C, high}], [λ_{M, low}, λ_{M, high}] and [λ_{Y, low}, λ_{Y,high}], respectively. Preferably, the lower and higher sensitivity limits of transparent pixels are matched to those of CMY colors of the invention, such that λ_{C, low} = λ_{T, low}; λ_{M, low} = λ_{T, low}; λ_{Y, high} = λ_{T, high} ; and/or λ_{M, high} = λ_{T, high}.

In the case of a stereo vision system with two imaging devices 12, both imaging devices could have image sensors under the present invention, either identical imaging devices, or imaging devices with two different image sensors under the invention, for example one YTTC sensor and one CTTM sensor. Alternatively, one imaging device could have an image sensor under the present invention, and the other imaging device could have a different image sensor, for example an image sensor without color filter array.

## Claims

1. An image sensor (21) for a vision device, said image sensor (21) comprising a sensor array (22) and a color filter array (23) arranged on top of said sensor array (22), said color filter array (23) having of a plurality of pixel filters, wherein said pixel filters consist of first color pixels, second color pixels and transparent pixels, **characterized in that** said first and second color pixels are chosen from the group consisting of Cyan, Magenta, Yellow.

2. The image sensor as claimed in claim 1, **characterized in that** said first and second color pixels are Magenta and Cyan pixels.

3. The image sensor as claimed in claim 1, **characterized in that** said first and second color pixels are Yellow and Magenta pixels.

4. The image sensor as claimed in claim 1, **characterized in that** said first and second color pixels are Yellow and Cyan pixels.

5. The image sensor as claimed in any one of the preceding claims, **characterized in that** said color filter array (23) is composed of 2 x 2 pixel patterns with two transparent pixels arranged diagonally and first color pixel second color pixel arranged diagonally.

6. The image sensor as claimed in any one of the preceding claims, **characterized in that** the ratio of transparent pixels to color pixels is in the range between 0.5 and 2.

7. The image sensor as claimed in any one of the preceding claims, **characterized in that** the ratio of first color pixels to second color pixels is in the range between 0.5 and 2.

8. A vision device (12) for a motor vehicle, comprising an image sensor (21) as claimed in any one of the preceding claims.

9. A vision system (10) for a motor vehicle, comprising at least one vision device (12) as claimed in claim 8.

10. The vision system as claimed in claim 9, **characterized in that** said vision system (10) is a mono vision system or a stereo vision system.

11. A vision method for a motor vehicle, comprising capturing images of a region outside a motor vehicle using a vision system with an imaging device having an image sensor as claimed in any one of the preceding claims.

12. The vision method as claimed in claim 11, comprising detecting object candidates in the captured images by an object detector based on image processing, and classifying said detected object candidates by a classifier, **characterized in that** said object detector and/or said classifier is adapted to use color information provided by said image sensor in said classification.
